# EUROPEAN PATENT APPLICATION

(11) **EP 4 565 041 A2**
(43) Date of publication of application: **04.06.2025**
(21) Application number: 24211195.3
(22) Date of filing: 06.11.2024
(51) Int. Cl.: H10K 50/115, H10K 59/80, H10K 59/122, H10K 59/12, H10K 59/131, H10K 71/13, H10K 102/00

(54) **DISPLAY PANEL, DISPLAY APPARATUS, AND METHOD FOR MANUFACTURING DISPLAY PANEL**

(30) Priority: 28.11.2023 CN 202311607036
(71) Applicant: Yungu (Gu'an) Technology Co., Ltd., Langfang, Hebei 065500 (CN)
(72) Inventor: YAN, Zhimin, Langfang, Hebei, 065500 (CN); JIAO, Fuxing, Langfang, Hebei, 065500 (CN)
(74) Representative: Kraus & Lederer PartGmbB

(57) **Abstract**

Embodiments of the present application provides a display panel (10), a display apparatus, and a manufacturing method for the display panel (10), the display panel (10) comprising: a substrate (100); a first power signal line (200), provided on the substrate (100); a conductive layer (300), provided on the first power signal line (200) and comprising a plurality of conductive portions (310) interconnected with the first power signal line (200); a pixel defining layer (400), comprising a pixel defining portion (410) as well as a first opening (420) and a second opening (430) opened in the pixel defining portion (410), an orthographic projection of the second opening (430) on the substrate (100) and an orthographic projection of the conductive portion (310) on the substrate (100) being at least partially overlap; a light emitting layer (500), provided on a side of the substrate (100) where the conductive layer (300) is located, the light emitting layer (500) comprising a plurality of light emitting portions (510), at least part of which being located in the first openings (420); a dam portion, provided on the substrate (100) and surrounding the conductive portion (310); a first electrode, provided on a side of the light emitting layer (500) and the dam portion away from the substrate (100) and interconnected with the conductive portion (310) via the second opening (430). The application may improve the display performance of the display panel.

## Description

### TECHNICAL FIELD

The present application relates to the technical field of display apparatus, and in particular to a display panel, a display apparatus, and a method for manufacturing a display panel.

### BACKGROUND

Organic Light -Emitting Diode (OLED) displays also known as organic electrolight emitting displays, have a series of advantages over existing LCD displays, such as autonomous light emitting, wide viewing angle, ultra-light, ultra-thin, high brightness, low power consumption, and fast response allowing a response speed up to 1000 times that of LCD displays. Therefore, OLED displays have become very popular flat panel display products at home and abroad, and have broad application prospects. Quantum dot (QD) materials have advantages of high luminescence color purity, adjustable luminescence wavelength, and material stability, with significant advantages in the field of pursuing high color gamut color display.

The quantum dot light emitting diode (QLED) is a new type of light emitting devices. Due to light emitting characteristics itself without a need for additional light sources, as well as its advantages such as narrow light emitting peak, adjustable light emitting color, and high light emitting efficiency, QLED has gradually become one of the mainstream development directions of display technology in the future.

However, a display performance of current display products needs to be improved.

### SUMMARY

Embodiments of the present application provide a display panel, a display apparatus, and a method for manufacturing a display panel, which are aimed at improving the display performance of the display panel.

Embodiments of a first aspect of the present application provide a display panel, comprising: a substrate; a first power signal line provided on the substrate; a conductive layer provided over the first power signal line and connected with the first power signal line, the conductive layer comprising a plurality of conductive portions; a pixel defining layer comprising pixel defining portions, first openings and second openings that are formed in the pixel defining portions, orthographic projections of the second openings on the substrate and orthographic projections of the plurality of conductive portions on the substrate at least partially overlapping; a light emitting layer provided on a side of the substrate where the conductive layer is located, the light emitting layer comprising a plurality of light emitting portions disposed corresponding to the first openings; dam portions provided on the substrate and surrounding the plurality of conductive portions, a material of the dam portions having no affinity with a material of the light emitting portions; first electrodes provided on a side of the light emitting layer and the dam portions away from the substrate and connected with the conductive portions via the second openings.

According to an embodiment of the first aspect of the present application, the dam portions are located on a side of the pixel defining portions away from the substrate and are provided surrounding the second openings.

According to any one of the aforementioned embodiments of the first aspect of the present application, the pixel defining portions comprise first sections and second sections spaced apart from each other, the first openings are formed in the first sections, the second opening are formed in the second sections, the dam portions are located on a side of the second sections away from the substrate.

According to any one of the aforementioned embodiments of the application, the dam portions have first surfaces facing away from the substrate, and the first sections have second surfaces facing away from the substrate, the first surfaces are located on a side of the second surfaces facing away from the substrate.

According to any one of the aforementioned embodiments of the application, orthographic projections of the dam portions on the substrate are located within the second openings, and the dam portions are in direct contact with the substrate via the second opening.

According to any one of the aforementioned embodiments of the application, inner wall surfaces, facing the second openings, of the pixel defining portions are spaced apart from the dam portions.

According to any one of the aforementioned embodiments of the application, the display panel comprises overlapping areas distributed at intervals, and the plurality of conductive portions are located in the overlapping areas.

According to any one of the aforementioned embodiments of the application, the dam portions are located in the overlapping areas.

According to any one of the aforementioned embodiments of the application, the plurality of conductive portions are distributed at intervals along an extension direction of the overlapping areas.

According to any one of the aforementioned embodiments of the application, orthographic projections of the plurality of conductive portions on the substrate each are in a circular shape.

According to any one of the aforementioned embodiments of the application, orthographic projections of the dam portions on the substrate each are in a circular ring shape.

According to any one of the aforementioned embodiments of the application, the overlapping area is in a strip shape, a plurality of the overlapping areas being provided side by side along a first direction and/or a second direction, the first direction and the second direction intersecting.

According to any one of the aforementioned embodiments of the application, the overlapping areas are in strip shapes, and are provided side by side along a first direction or a second direction, the first direction is intersected with the second direction; the extension dimension of the overlapping areas in the second direction is greater than the extension dimension of the overlapping areas in the first direction, and the overlapping areas are provided side by side along the first direction.

According to any one of the aforementioned embodiments of the application, a width of one of the overlapping areas in the first direction is 10 µm to 50 µm, and a length of one of the overlapping areas in the second direction is greater than or equal to 10 µm.

According to any one of the aforementioned embodiments of the application, a distance between two adjacent ones of the overlapping areas is greater than or equal to 5 µm.

According to any one of the aforementioned embodiments of the application, the display panel further comprises a display area, the overlapping areas being evenly distributed in the display area.

According to any one of the aforementioned embodiments of the application, the overlapping areas each are in a square shape.

According to any one of the aforementioned embodiments of the application, a distance between adjacent two of the overlapping areas is less than or equal to 50 µm, or a spacing between adj acent two of the overlapping areas is greater than or equal to 80 µm.

According to any one of the aforementioned embodiments of the application, the dam portions have side surfaces facing and being connected with the bottom surface of the substrate, and extending away from the substrate, an angle between the side surfaces and the bottom surface is greater than or equal to 10 degrees and less than or equal to 70 degrees.

According to any one of the aforementioned embodiments of the application, a thickness d1 of one of the dam portions and a thickness d2 of one of the light emitting portions satisfy the following condition: d1 ≥ 15d2.

According to any one of the aforementioned embodiments of the application, the thickness d1 of one of the dam portions is 200nm to 10µm.

According to any one of the aforementioned embodiments of the application, a width of one of the dam portions is 2 µm to 10 µm.

According to any one of the aforementioned embodiments of the application, surfaces of the conductive portions facing the first electrodes are provided with grooves.

According to any one of the aforementioned embodiments of the application, the grooves are provided at intervals.

According to any one of the aforementioned embodiments of the application, each of the grooves extends along the first direction, and the grooves are provided side by side along the second direction.

According to any one of the aforementioned embodiments of the application, further comprising: a second electrode layer located on a side of the pixel defining layer facing the substrate, and the second electrode layer comprising second electrodes provided corresponding to the first openings, wherein the conductive portions and the second electrodes are provided in a same layer; or, the substrate is further provided with a planarization layer located on a side of the second electrode layer away from the pixel defining layer, the conductive layer is located on a side of the planarization layer away from the second electrode layer, connecting holes are formed in the planarization layer, and the first electrodes are connected with the conductive portions via the connecting holes.

According to any one of the aforementioned embodiments of the application, the conductive portions are in contact with and connected with the first power signal line; or, the conductive layer is connected with the first power signal line through a via.

According to any one of the aforementioned embodiments of the application, surfaces of the dam portions facing away from the substrate is hydrophobic or oleophobic surfaces with low surface energy.

Embodiments of a second aspect of the application further provides a display panel, comprising: a substrate; a first power signal line provided on the substrate; a conductive layer provided over the first power signal line and comprising a plurality of conductive portions connected with the first power signal line; a pixel defining layer comprising pixel defining portions, first openings and second openings that are formed in the pixel defining portions, orthographic projections of the second openings on the substrate and orthographic projections of the plurality of conductive portions on the substrate at least partially overlapping; a light emitting layer provided on a side of the substrate where the conductive layer is located, the light emitting layer comprising a plurality of light emitting portions at least partially being located in the first openings; dam portions provided on the substrate and surrounding the plurality of conductive portions, a material of the dam portions having no affinity with a material of the light emitting portions; first electrodes provided on a side of the light emitting layer and the dam portions away from the substrate and connected with the conductive portions via the second openings.

Embodiments of a third aspect of the application further provides a method for manufacturing a display panel, comprising:
providing a conductive material layer on a substrate, and patterning the conductive material layer to form a first power signal line;
further providing a conductive material layer on the substrate with the first power signal line, and patterning the conductive material layer to form a conductive layer comprising a plurality of conductive portions located on a side of the first power signal line away from the substrate;
providing a pixel defining material layer on the substrate, and patterning the pixel defining material layer to form first openings and second openings, at least part of the conductive portions being exposed via the second openings;
providing a hydrophobic material layer on the substrate, and patterning the hydrophobic material layer to obtain dam portions provided surrounding the conductive portions;
further manufacturing a light emitting layer comprising a plurality of light emitting portions on the substrate, the light emitting portions being at least partially located in the first openings;
further manufacturing first electrodes on the substrate, the first electrodes being connected with the conductive portions via the second openings.

According to embodiments of a third aspect of the application, the display panel comprises overlapping areas, the light emitting portions comprising connecting openings located in the overlapping areas, the conductive portions being provided in the overlapping areas, an extension dimension of the overlapping areas in a first direction being greater than an extension dimension of the overlapping areas in a second direction, and in the step of further manufacturing the light emitting layer on the substrate:
a plurality of nozzles provided side by side are moved along the first direction to apply a light emitting material on the substrate, and one or more adjacent nozzles are closed for a preset period of time to form the light emitting portions comprising the connecting openings in the overlapping areas.

In a display panel provided in an embodiment of the present application, the display panel comprises a substrate, a first power signal line, a conductive layer, a pixel defining layer, a light emitting layer, dam portions, and first electrodes. The light emitting portions of the light emitting layer are provided in the first openings formed in the pixel defining portions, and a problem of color crosstalk of different light emitting portions can be improved via the pixel defining portions. Second openings are further provided in the pixel defining portions, and orthographic projections of the second openings on the substrate and orthographic projections of the conductive portions on the substrate at least partially overlap, so that the conductive portions can be exposed via the second openings, and the first electrodes can be connected with the conductive portions via the second openings. The conductive portions of the conductive layer are connected with the first power signal line, thus the first electrodes can be connected with the first power signal line via the conductive portions, which can improve the problem of excessive voltage drop of the first electrodes and improve the display effect of the display panel. In addition, dam portions surrounding the conductive portions are further provided on the substrate. A material of the dam portions has no affinity with a material of the light emitting portions. When manufacturing the light emitting portions, the blocking and hydrophobic effect of the dam portions can improve the overflow of the material of the light emitting portions onto the conductive portions and affect the electrical connection of the first electrodes and the conductive portions, thereby improving the connection yield of the first electrodes and the conductive portions, better improving the voltage drop problem of the first electrodes, and improving the display effect of the display panel. Therefore, an embodiment of the present application can improve the display performance of the display panel by providing the dam portions.

### BRIEF DESCRIPTION OF THE DRAWINGS

Other features, objects and advantages of the present application will become more apparent by reading the following detailed description of non-limiting embodiments with reference to the accompanying drawings, in which the same or similar reference numerals represent the same or similar features.
Fig. 1 is a schematic structural diagram of a display panel provided in an embodiment of the present application;
Fig. 2 is a cross-sectional view along A-A in Fig. 1 in an example;
Fig. 3 is a cross-sectional view along A-A in Fig. 1 in another example;
Fig. 4 is a partially enlarged schematic structural diagram of a display panel provided in an embodiment of the present application;
Fig. 5 is a cross-sectional view along A-A in Fig. 1 in another example;
Fig. 6 is a schematic structural diagram of a conductive portion and a dam portion of a display panel provided in an embodiment of the present application;
Fig. 7 is a schematic structural diagram of a conductive portion and a dam portion of a display panel provided by another embodiment of the present application;
Fig. 8 is a schematic structural diagram of a conductive portion and a dam portion of a display panel provided by another embodiment of the present application;
Fig. 9 is a schematic structural diagram of a display panel provided by another embodiment of the present application;
Fig. 10 is an enlarged structural schematic diagram of a dam portion of a display panel provided in an embodiment of the present application;
Fig. 11 is a cross-sectional view along A-A in Fig. 1 in another example;
Fig. 12 is a partial cross-sectional view of a conductive portion of a display panel provided in an embodiment of the present application;
Fig. 13 is a partial enlarged view of a conductive portion of a display panel provided in an embodiment of the present application;
Fig. 14 is a partial cross-sectional view of a conductive portion of a display panel provided in another embodiment of the present application;
Fig. 15 is a cross-sectional view along A-A in Fig. 1 in another example;
Fig. 16 is a schematic structural diagram of a light emitting portion of a display panel provided in an embodiment of the present application;
Fig. 17 is a flow chart of a method for manufacturing a display panel provided in an embodiment of the present application;
Figs. 18 to 22 are schematic structural diagrams of a display panel manufacturing process provided in an embodiment of the present application.

### DETAILED DESCRIPTION

The features and exemplary embodiments of various aspects of the present application will be described in detail below. In the detailed description below, many specific details are proposed to provide a comprehensive understanding of the present application. However, it is obvious to those skilled in the art that the present application can be implemented without the need for some of these specific details. The following description of the embodiments is only to provide a better understanding of the present application by illustrating examples of the present application. In the accompanying drawings and the following description, at least part of the known structures and technologies are not shown to avoid unnecessary ambiguity in the present application; and, for clarity, the size of some structures may be exaggerated. In addition, the features, structures or characteristics described below may be combined in one or more embodiments in any suitable manner.

In the description of the present application, it should be noted that, unless otherwise specified, "plurality" means more than two; the directions or positional relationships indicated by the terms "upper", "lower", "left", "right", "inner", "outer", etc. are only for the convenience of describing the present application and simplifying the description, and do not indicate or imply that the apparatus or element referred to must have a specific direction, be constructed and operated in a specific direction, and therefore cannot be understood as limiting the present application. In addition, the terms "first", "second", etc. are only used for descriptive purposes and cannot be understood as indicating or implying relative importance.

The directional words appearing in the following description are all directions shown in the figures, and do not limit the specific structure of the embodiments of the present application. In the description of the present application, it should also be noted that, unless otherwise clearly specified and limited, the terms " installation " and " connection " should be understood in a broad sense, for example, it can be a fixed connection, a detachable connection, or an integral connection; it can be directly connected or indirectly connected. For ordinary technicians in this field, the specific meanings of the above terms in this application can be understood according to the specific circumstances.

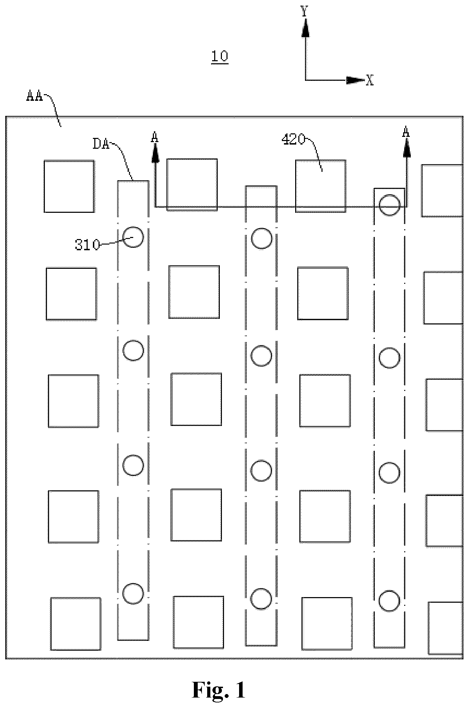

In order to better understand the present application, the display panel, the display apparatus and the method for manufacturing the display panel according to embodiments of the present application are described in detail below with reference to Figs. 1 to 22.

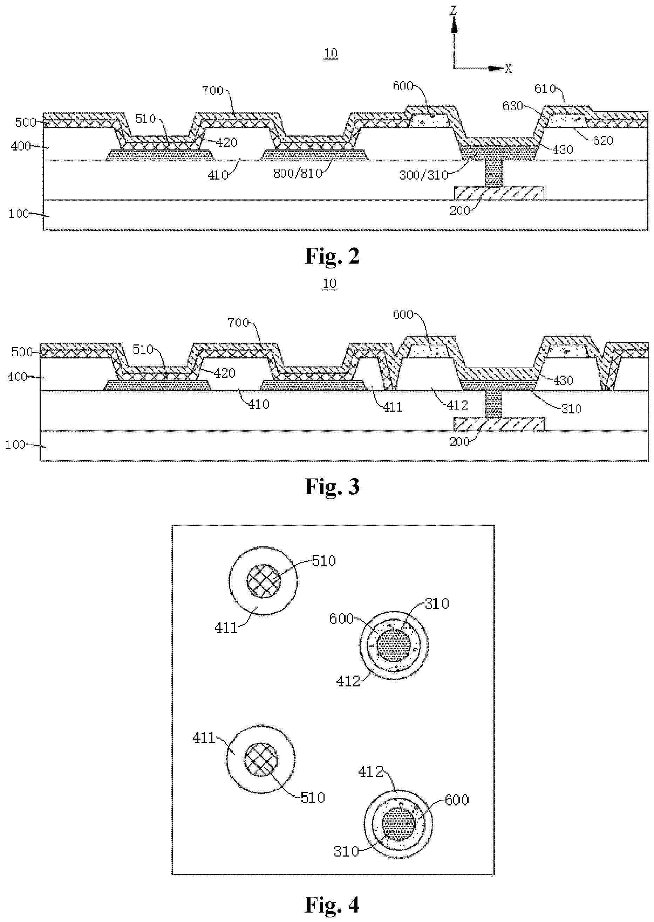

Please refer to Fig. 1 and Fig. 2, in which Fig. 1 is a schematic structural diagram of a display panel 10 provided in an embodiment of the present application, and Fig. 2 is a cross-sectional view along A-A in Fig. 1 in an example.

As shown in Figs. 1 and 2, an embodiment of a first aspect of the present application provides a display panel 10, comprising a substrate 100, a first power signal line 200, a conductive layer 300, a pixel defining layer 400, a light emitting layer 500, a dam portion 600 and a first electrode 700. The first power signal line 200 is provided on the substrate 100; the conductive layer 300 is provided on the first power signal line 200 and comprises a plurality of conductive portions 310, and the conductive portions 310 are connected with the first power signal line 200; the pixel defining layer 400 comprises a pixel defining portion 410 as well as a first opening 420 and a second opening 430 opened in the pixel defining portion 410, an orthographic projection of the second opening 430 on the substrate 100 and an orthographic projection of the conductive portion 310 on the substrate 100 at least partially overlap; the light emitting layer 500 is provided on a side of the substrate 100 where the conductive layer 300 is located, the light emitting layer 500 comprises a plurality of light emitting portions 510, and at least part of the light emitting portions 510 are located in the first openings 420; the dam portion 600 is provided on the substrate 100 and surrounds the conductive portion 310, a material of the dam portion 600 has no affinity with a material of the light emitting portion 510; the first electrode 700 is provided on a side of the light emitting layer 500 and the dam portion 600 away from the substrate 100 and is connected with the conductive layer 300 via the second opening 430.

In a display panel 10 provided by an embodiment of the present application, the display panel 10 comprises a substrate 100, a first power signal line 200, a conductive layer 300, a pixel defining layer 400, a light emitting layer 500, a dam portion 600, and a first electrode 700. The light emitting portion 510 of the light emitting layer 500 is provided in a first opening 420 formed in the pixel defining portion 410, and the problem of color crosstalk of different light emitting portions 510 can be improved by means of the pixel defining portion 410. A second opening 430 is further provided in the pixel defining portion 410, the orthographic projection of the second opening 430 on the substrate 100 and the orthographic projection of the conductive portion 310 on the substrate 100 at least partially overlap, so that the conductive portion 310 can be exposed by the second opening 430, and the first electrode 700 can be connected with the conductive portion 310 via the second opening 430. The conductive portion 310 of the conductive layer 300 is connected with the first power signal line 200, thus the first electrode 700 can be connected with the first power signal line 200 via the conductive portion 310, which can improve the problem of excessive voltage drop of the first electrode 700 and improve the display effect of the display panel 10. In addition, a dam portion 600 surrounding the conductive portion 310 is further provided on the substrate 100. The material of the dam portion 600 has no affinity with the material of the light emitting portion 510. When manufacturing the light emitting portion 510, the blocking and hydrophobic effect of the dam portion 600 can improve the overflow of the material of the light emitting portion 510 onto the conductive portion 310 and affect the electrical connection of the first electrode 700 and the conductive portion 310, improving the connection yield of the first electrode 700 and the conductive portion 310, better improving the voltage drop problem of the first electrode 700, and improving the display effect of the display panel 10. Therefore, embodiments of the present application can improve the display performance of the display panel 10 by providing the dam portion 600.

By "the material of the dam portion 600 has no affinity with the material of the light emitting portion 510", it is meant that the material of the dam portion 600 and the material of the light emitting portion 510 are not easily compatible, the material of the light emitting portion 510 is not easily retained on the dam portion 600, and the material of the dam portion 600 and the material of the light emitting portion 510 are repulsed each other. For example, the material of the dam portion 600 comprises a hydrophobic material, and the material of the light emitting portion 510 comprises water, so that the material of the light emitting portion 510 is not easily retained on the dam portion 600.

Optionally, the dam portion 600 has a hydrophobic and/or oleophobic low-energy surface, so that when manufacturing the light emitting portion 510, the blocking and hydrophobic effects of the dam portion 600 can improve the overflow of material from the light emitting portion 510 onto the conductive portion 310 and affect the electrical connection of the first electrode 700 and the conductive portion 310, thereby improving the connection yield of the first electrode 700 and the conductive portion 310.

The first power signal line 200 may be, for example, a low-level power signal line, or a negative voltage power signal line.

The conductive layer 300 can be provided adjacent to a film layer where the first power signal line 200 is located, so that the conductive portion 310 is in contact and connected with the first power signal line 200, or other film layers can be provided between the conductive layer 300 and the first power signal line 200, and the conductive portion 310 can be connected with the first power signal line 200 through a via.

There are many ways to set the light emitting portion 510. For example, the material of the light emitting portion 510 comprises ink, and the light emitting portion 510 is manufactured on the pixel defining layer 400 by process of inkjet printing, coating, etc. The light emitting portion 510 can be a quantum dot light emitting diode. In other embodiments, the light emitting portion 510 can be an organic light emitting diode.

There are many ways to set the dam portion 600. For example, the material of the dam portion 600 comprises a hydrophobic material, and the material of the dam portion 600 comprises, but is not limited to, hydrophobic materials such as polyimide, epoxy resin, acrylic resin, silicone resin, silicon nitride, and silicon oxide. Or the material of the dam portion 600 comprises a strongly hydrophobic and/or oleophobic material, for example, the material of the dam portion 600 comprises groups such as perfluoromethyl, perfluoroethyl, and perfluorobenzene, etc. Thus the dam portion 600 has good hydrophobic properties, which improves the problem of the material of the light emitting portion 510 overflowing onto the conductive portion 310. The hydrophobic material has a hydrophobic property, and the hydrophobic property herein refers to the "hydrophobic and oleophobic" property, which refers to the property that the liquid is not easy to adhere to and contact with the dam portion 600. The hydrophobic property refers to the difficulty in contacting with the liquid, rather than simply the difficulty in contacting with water. The material of the dam portion 600 comprises a hydrophobic material, so that the surface of the dam portion 600 away from the substrate 100 is a low-energy surface.

The dam portion 600 may be provided at various positions. For example, in some optional embodiments, the dam portion 600 is located on a side of the pixel defining portion 410 away from the substrate 100 and is provided surrounding the second opening 430.

In these optional embodiments, the dam portion 600 is directly provided on the pixel defining portion 410, so that the height of the dam portion 600 relative to the substrate 100 is greater than the height of the pixel defining portion 410 relative to the substrate 100, and the dam portion 600 protrudes from the pixel defining portion 410. In addition, the dam portion 600 is provided surrounding the second opening 430, and when the light emitting material overflows to a periphery side of the dam portion 600, the dam portion 600 can block the light emitting material outside the second opening 430, thereby better improving the problem of the electrical connection of the first electrode 700 and the first power signal line 200 affected by the overflow of the light emitting material onto the conductive portion 310.

In some optional embodiments, with reference to Figs. 1 and 3, the pixel defining portion 410 comprises a first section 411 and a second section 412 spaced apart, the first opening 420 is opened on the first section 411, the second opening 430 is opened on the second section 412, and the dam portion 600 is located on a side of the second section 412 away from the substrate 100.

In these optional embodiments, the pixel defining portion 410 is divided into a first section 411 and a second section 412 spaced apart, and there is a gap between the first section 411 and the second section 412. When the light emitting material overflows from the first opening 420 of the first section 411 to the second opening 430 of the second section 412, at least part of the light emitting material overflows into the gap between the first section 411 and the second section 412. By accommodating the overflowing light emitting material via the gap, the volume of the light emitting material overflowing to the side of the dam portion 600 away from the second opening 430 can be further reduced, thereby better improving the problem of affecting the electrical connection of the first electrode 700 and the first power signal line 200 due to the overflow of the light emitting material onto the conductive portion 310.

There are many ways to set the shapes of the first section 411 and the second section 412. For example, as shown in Figs. 3 and 4, the first section 411 is annular, and the first opening 420 is located in the annular first section 411. And/or, the second section 412 is annular, and the second opening 430 is located in the annular second section 412. A plurality of first sections 411 and a plurality of second sections 412 are distributed at intervals on the substrate 100.

Optionally, the dam portion 600 has a first surface 610 away from the substrate 100, the first section 411 has a second surface 401 away from the substrate 100, and the first surface 610 is located on a side of the second surface 401 away from the substrate 100.

In these optional embodiments, the dam portion 600 protrudes relative to the first section 411 in a direction away from the substrate 100, that is, the first surface 610 protrudes relative to the second surface 401, and the height of the dam portion 600 relative to the substrate 100 is greater than the height of the first section 411 relative to the substrate 100. When the light emitting material is provided in the first opening 420, due to the obstruction of the dam portion 600, it is difficult for the light emitting material to fall on the first surface 610 of the dam portion 600, and then it is difficult for the light emitting material to overflow to the second opening 430, thereby further improving the hydrophobic effect of the dam portion 600 and improving the connection yield of the first electrode 700 and the conductive portion 310.

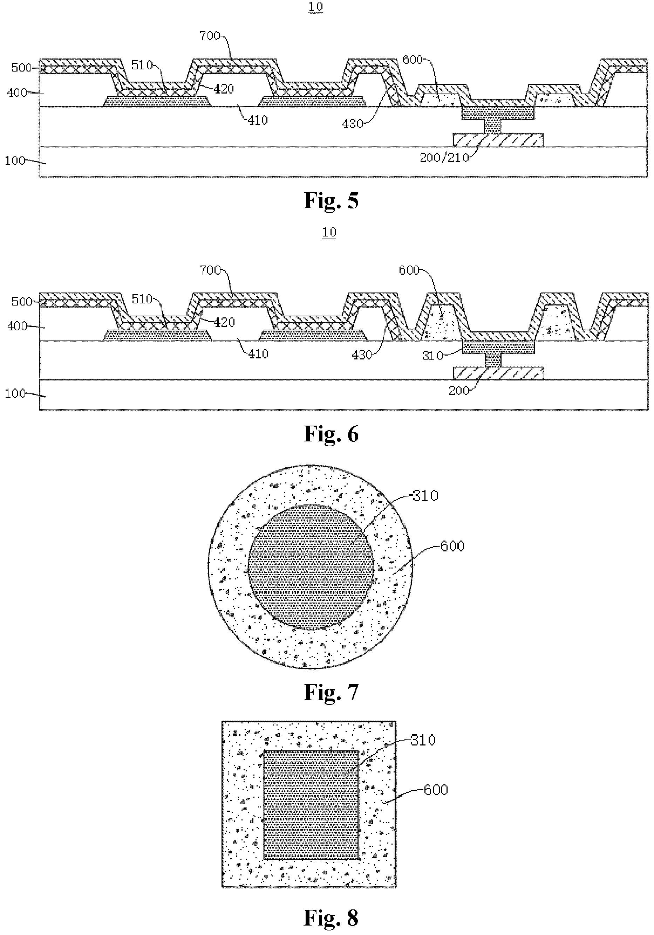

In some other optional embodiments, as shown in Fig. 5, the orthographic projection of the dam portion 600 on the substrate 100 is located within the second opening 430, and the dam portion 600 is in direct contact with the substrate 100 via the second opening 430.

In these optional embodiments, the dam portion 600 falls into the second opening 430, the dam portion 600 is provided surrounding the conductive portion 310 in the second opening 430, and there is no pixel defining portion 410 between the dam portion 600 and the substrate 100, which can simplify the method for manufacturing the dam portion 600.

Optionally, an opening size of the second opening 430 is larger than a size of the conductive portion 310 exposed thereby, that is, the orthographic projection of the conductive portion 310 on the substrate 100 is located within the orthographic projection of the second opening 430 on the substrate 100, so as to ensure that a sufficiently large area of the conductive portion 310 can be exposed.

Optionally, the dam portion 600 surrounds the conductive portion 310 exposed via the second opening 430. The dam portion 600 and the conductive portion 310 may be spaced apart, that is, the conductive portion 310 is located in the area enclosed by the dam portion 600, and the conductive portion 310 and the dam portion 600 are spaced apart. Alternatively, the dam portion 600 and the conductive portion 310 are adjacent, and the dam portion 600 surrounds the conductive portion 310 and is connected with an edge of the conductive portion 310. Alternatively, part of the dam portion 600 overlaps the conductive portion 310.

Optionally, an inner wall surface of the pixel defining portion facing the second opening is spaced apart from the dam portion.

In these optional embodiments, there is a gap between the inner wall surface of the pixel defining portion 410 facing the second opening 430 and the dam portion 600. When the light emitting material overflows from the first opening 420 to the second opening 430, part of the light emitting material can remain in the above gap, thereby reducing the light emitting material overflowing to the upper surface of the dam portion 600, better improving the hydrophobic effect of the dam portion 600, and improving the connection yield of the first electrode 700 and the conductive portion 310.

Optionally, when the dam portion 600 is located in the second opening 430, when the dam portion 600 and the pixel defining portion 410 are both provided on the substrate 100, the dam portion 600 and the pixel defining portion 410 can be at the same height, or, as shown in Fig. 5, the height of the dam portion 600 is lower than that of the pixel defining portion 410, that is, the first surface 610 is located on the side of the second surface 401 facing the substrate 100; or, as shown in Fig. 6, the height of the dam portion 600 is higher than that of the pixel defining portion 410, that is, the first surface 610 is located on the side of the second surface 401 away from the substrate 100, so as to better achieve hydrophobic properties.

In some optional embodiments, as shown in Fig. 1 and 2, the display panel 10 comprises an overlapping area DA, a plurality of the overlapping areas DA are distributed at intervals, and the conductive portion 310 is located in the overlapping area DA.

In these optional embodiments, the overlapping area DA is provided on the display panel 10, and the conductive portion 310 is provided in the overlapping area DA. When manufacturing the light emitting portion 510 by using a process such as inkjet printing or coating, the light emitting material may not be sprayed onto the substrate 100 in the overlapping area DA by controlling the nozzle and other components of the inkjet printing, thereby better improving the problem of the light emitting material overflowing to the conductive portion 310.

Optionally, the dam portion 600 is located in the overlapping area DA to better improve the problem of the light emitting material overflowing onto the conductive portion 310 in the overlapping area DA.

Optionally, the plurality of conductive portions 310 are spaced apart along an extension direction of the overlapping area DA. The plurality of conductive portions 310 are provided in the same overlapping area DA, so that the first electrode 700 can be electrically connected with the first power signal line 200 via the plurality of conductive portions 310, further improving the connection yield of the first electrode 700 and the first power signal line 200. As shown in Fig. 1, when the overlapping area DA is extending along the second direction Y, the conductive portions 310 can be spaced apart along the second direction Y.

Optionally, as shown in Fig. 7, the orthographic projection of the conductive portion 310 on the substrate 100 is circular, so that the light emitting material can spread at the periphery side of the conductive portion 310, thereby better improving the problem that the light emitting material easily overflows onto the conductive portion 310.

Optionally, as shown in Fig. 7, the orthographic projection of the dam portion 600 on the substrate 100 is in a circular ring shape, so that the light emitting material can spread on an outer periphery side of the dam portion 600 and is difficult to overflow onto the conductive portion 310.

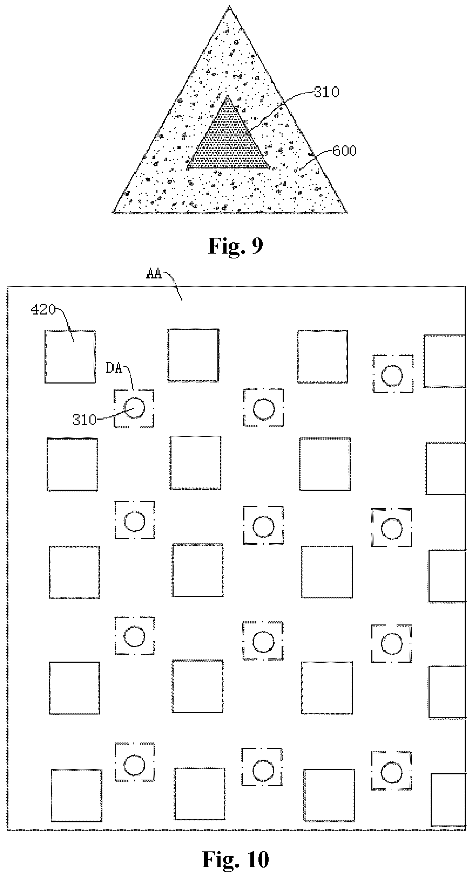

In other embodiments, as shown in Figs. 8 and 9, the orthographic projection of the conductive portion 310 on the substrate 100 may also be a polygon, such as a triangle, a square, etc. The shape of the dam portion 600 matches the shape of the conductive portion 310, and the orthographic projection of the dam portion 600 on the substrate 100 is a polygonal ring.

In some optional embodiments, still referring to Fig. 1, the overlapping area DA is in a strip shape, and a plurality of overlapping areas DA are provided side by side along the first direction X and/or the second direction Y, and the first direction X intersects the second direction Y. Fig. 1 takes for example that the overlapping area DA extends along the first direction X, and the plurality of overlapping areas DA are provided side by side along the second direction Y. In other embodiments, the overlapping area may extend along the second direction Y, and the plurality of overlapping areas DA are provided side by side along the first direction X.

In these optional embodiments, the overlapping area DA is in a strip shape. When the light emitting portion 510 is manufactured by coating or other processes, a long stripe-shaped overlapping area DA can be formed by closing one or two adjacent nozzle components, which facilitates the manufacturing and molding of the display panel 10.

Optionally, the extension dimension of the overlapping area DA in the second direction Y is greater than the extension dimension thereof in the first direction X, and the plurality of overlapping areas DA are provided side by side along the first direction X. As described above, the overlapping area DA is in a strip shape, and the plurality of strip-shaped overlapping areas DA are provided side by side along the first direction X. By closing one or more groups of nozzles, the plurality of overlapping areas DA provided side by side can be formed.

For example, the light emitting portion 510 is manufactured and formed by coating process, and the material of the light emitting portion 510 is placed in a plurality of containers with nozzle components, and a plurality of the nozzle components are provided side by side along the first direction X. Then the plurality of nozzle components are moved along the second direction Y and spray the material of the light emitting portion 510 on the corresponding substrate while moving, wherein the first direction X and the second direction Y intersect, for example, the first direction X and the second direction Y are perpendicular, so as to achieve the large area application of the material of the light emitting portion 510. During spraying, by closing one or more nozzles, an overlapping area DA where the material of the light emitting portion 510 is not set is formed, and the manufacturing method is simple, convenient and easy to operate.

Optionally, the width of the overlapping area DA in the first direction X is 10 µm to 50 µm, and the length of the overlapping area DA in the second direction Y is greater than or equal to 10 µm. When the size of the overlapping area DA is within the above range, it is convenient to form the overlapping area DA by closing the nozzle, and it can also provide a larger area for setting the conductive portion 310, which is convenient for the first electrode 700 to be connected with the conductive portion 310.

Optionally, a distance between two adjacent ones of the overlapping areas DA is greater than or equal to 5 µm. This can improve the problem that the distance between two adjacent ones of the overlapping areas is too small, which affects providing the light emitting portion 510 and the light emitting effect of the display panel 10, and can also improve the problem that the distance between two adjacent ones of the overlapping areas DA is too large, which affects the electrical connection of the first electrode 700 and the conductive portion 310.

In some other optional embodiments, as shown in Fig. 10, the display panel 10 further comprises a display area AA, and the plurality of overlapping areas DA are distributed in the display area AA evenly.

In these embodiments, the overlapping areas DA are dot-shaped and evenly distributed in the display area AA, so that the plurality of conductive portions 310 can be distributed in the display area AA evenly, thereby improving the overlapping yield of the first electrode 700 and the conductive portion 310.

In these optional embodiments, the light emitting material can be printed onto the substrate 100 using a pixel-level printing apparatus to form the light emitting portion 510.

Optionally, the shape of the overlapping area DA can be square, which is convenient for manufacturing and molding the overlapping area. Optionally, the distance between two adjacent overlapping areas DA is less than or equal to 50 µm, so that the light emitting material can be printed using a pixel-level printing apparatus. Alternatively, the distance between two adjacent overlapping areas DA is greater than or equal to 80 µm, so that the light emitting material can be printed using a non-pixel-level printing apparatus.

For example, when the light emitting portion 510 is manufactured, the light emitting material may be printed onto a preset substrate using a pixel-level printing apparatus, avoiding the position of the overlapping area DA during printing to form an overlapping area DA not coated with the light emitting material.

There are many ways to set the shape of the dam portion 600. In a direction away from the substrate 100, the cross section of the dam portion 600 can be set to be uniform.

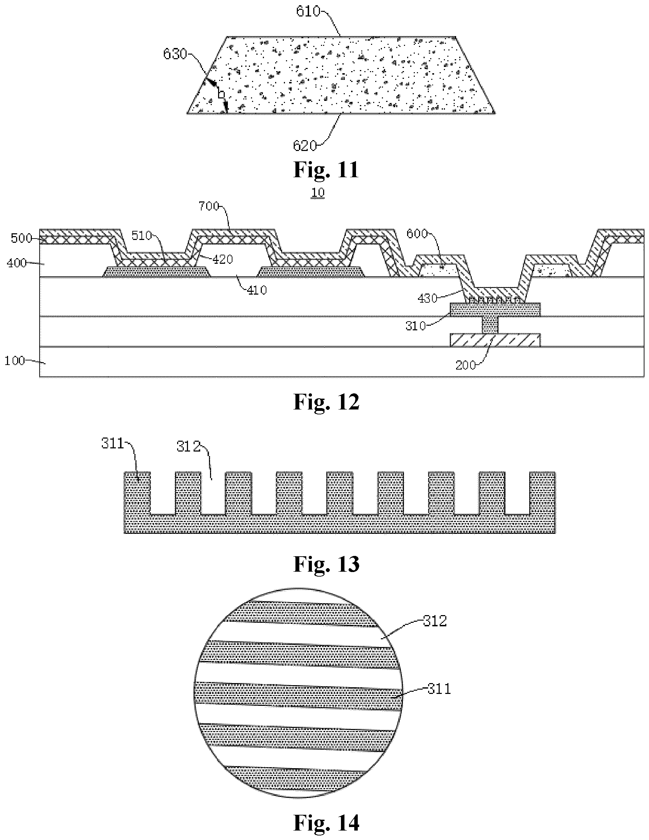

Alternatively, in other embodiments, as shown in Figs. 2 and 11, the dam portion 600 has a bottom surface 620 facing the substrate 100, a top surface (i.e., the first surface 610) facing away from the substrate 100, and a side surface 630 connecting the top surface and the bottom surface 620, i.e., the side surface 630 is connected with the bottom surface 620 and extends away from the substrate 100, and an angle b between the side surface 630 and the bottom surface 620 is greater than or equal to 10 degrees and less than or equal to 70 degrees.

In these optional embodiments, the angle b between the side surface 630 and the bottom surface 620 is between 10 degrees and 70 degrees, which can reduce the distribution area of the dam portion 600 and improve the continuity of the first electrode 700 affected by the large angle, improving the problem of the first electrode 700 being prone to breakage at the perimeter of the dam portion 600.

In some optional embodiments, the thickness di of the dam portion 600 and the thickness d₂ of the light emitting portion 510 satisfy: d₁ ≥ 15d₂.

In these optional embodiments, when d₁ and d₂ satisfy the above relationship, the problem that the thickness di of the dam portion 600 is too small and thus affects the blocking effect of the dam portion 600 on the light emitting material can be improved, and the hydrophobic effect can be further improved.

Optionally, the thickness di of the dam portion 600 is 200nm to 10µm. When the thickness of the dam portion 600 is within the above range, the problem that the thickness di of the dam portion 600 is too small and affects the blocking effect of the dam portion 600 on the light emitting material can improved; the problem that the thickness di of the dam portion 600 is too large and affects the continuity of the first electrode 700 can also be improved, improving the problem that the first electrode 700 is easy to break at the perimeter of the dam portion 600.

Optionally, the width of the dam portion 600 is 2 µm to 10 µm. When the width of the dam portion 600 is within the above range, the problem that the width of the dam portion 600 is too small and affects the hydrophobic effect can be improved, and the problem that the width of the dam portion 600 is too large and affects the distribution area of the light emitting portion 510 and affects the display effect of the display panel 10 can also be improved.

There are many ways to provide the conductive portion 310. In some optional embodiments, as shown in Figs. 12 and 13, a groove 311 is provided on a surface of the conductive portion 310 facing the first electrode 700.

In these optional embodiments, when the dam portion 600 does not completely block the light emitting material, and part of the light emitting material overflows from the dam portion 600 onto the conductive portion 310, the light emitting material tends to flow in the groove 311 provided near the dam portion 600, and the groove 311 can block part of the light emitting material from continuing to flow toward a central area of the conductive portion 310, so that the first electrode 700 can be connected with the conductive portion 310 via the central area of the conductive portion 310, thereby improving the connection yield of the first electrode 700 and the conductive portion 310. In addition, when the light emitting material is confined in the groove 311, protrusions 312 located on both sides of the groove 311 can be exposed from the groove 311, and the protrusions 312 are not easily covered by the light emitting material, thereby improving the connection yield of the first electrode 700 and the conductive portion 310.

There are many ways to provide the grooves 311. For example, a plurality of grooves 311 are provide on a surface of the dam portion 600, which can improve the hydrophobic effect of the surface of the conductive portion 310.

Optionally, as shown in Fig. 14, the groove 311 is formed extending along the first direction X, and a plurality of grooves 311 are provided side by side along the second direction Y. By providing the plurality of grooves 311 provided side by side, the hydrophobic effect can be further improved.

Optionally, the surface of the conductive portion 310 away from the substrate 100 has a protrusion 312, and the groove 311 is formed between two adjacent protrusions 312. In some optional embodiments, the display panel 10 further comprises a second electrode layer 800 located on a side of the pixel defining layer 400 facing the substrate 100 and comprising a second electrode 810 provided corresponding to the first opening 420.

In these optional embodiments, the second electrode 810 and the first electrode 700 interact to drive the light emitting portion 510 to emit light. One of the first electrode 700 and the second electrode 810 is an anode, and the other is a cathode. Embodiments of the present application are illustrated by taking the first electrode 700 as a cathode and the second electrode 810 as an anode.

When the display panel 10 comprises the second electrode 810, as shown in Fig. 3, the conductive portion 310 and the second electrode 810 can be provided in the same layer, so that the conductive portion 310 and the second electrode 810 can be manufactured and formed in the same process step, which can simplify the manufacturing process of the display panel 10. At this time, the conductive portion 310 can be via connected with the first power signal line 200.

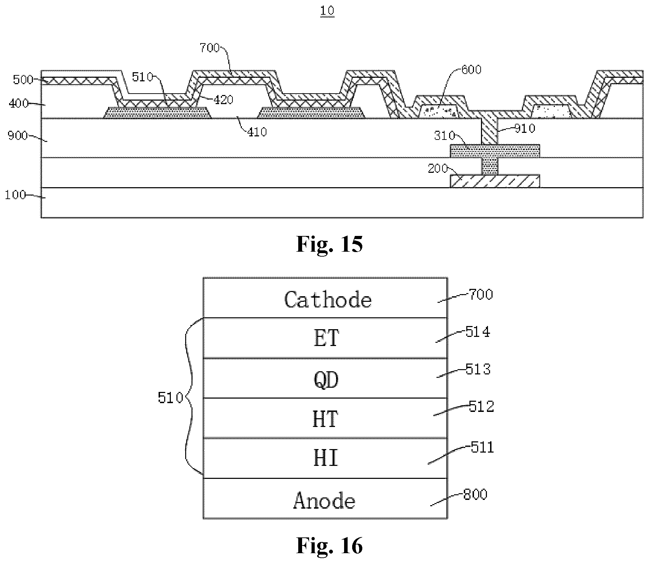

In other embodiments, as shown in Fig. 15, a planarization layer 900 located on the side of the second electrode layer 800 away from the pixel defining layer 400 is further provided on the substrate 100, and the conductive layer 300 is located on the side of the planarization layer 900 away from the second electrode layer 800. A connecting hole 910 is formed in the planarization layer 900, and the first electrode 700 is connected with the conductive portion 310 via the connecting hole 910.

In these optional embodiments, the conductive portion 310 and the second electrode 810 are provided in different layers, the conductive portion 310 is located on the side of the second electrode 810 facing the substrate 100, a connecting hole 910 is opened on the planarization layer 900, the connecting hole 910 is connected with the second opening 430, and the first electrode 700 is solidified and connected with the conductive portion 310 via the connecting hole 910. At this time, the conductive portion 310 can be connected with the first power signal line 200 through a via, for example, the conductive portion 310 and the first power signal line 200 are located in different film layer structures, and further, the first power signal line 200 can be located in a film layer structure on the side of the conductive layer 300 facing the substrate 100, so that the conductive portion 310 can be connected with the first power signal line 200 through a via. Alternatively, the conductive portion 310 and the first power signal line 200 are located in adjacent film layer structures, and the conductive portion 310 and the first power signal line 200 are directly contacted and connected, so as to improve the connection yield of the conductive portion 310 and the first power signal line 200.

There are many ways to set the light emitting portion 510. Optionally, as shown in Fig. 16, the light emitting portion 510 comprises a hole injection layer 511, a hole transport layer 512 and a light emitting material layer 513, which are stacked. The light emitting material layer 513 can be a quantum dot material, thus for one of the hole injection layer 511 and the hole transport layer 512, the relevant ink can be provided on the substrate 100 using inkjet printing, coating and other processes. In the display panel 10 provided in the embodiments of the present application, due to the presence of the dam portion 600, when manufacturing the hole injection layer 511 and/or the hole transport layer 512, it is possible to improve the problem that the ink overflows to the hydrophobic overlap portion affecting the electrical connection of the first electrode 700 and the first power signal line 200. Optionally, the light emitting portion 510 further comprises an electron transport layer 514, provided between the first electrode 700 and the light emitting material layer 513.

Embodiments of a second aspect of the present application further provides a display apparatus, comprising the display panel 10 of any of the above-mentioned embodiments of the first aspect. Since the display apparatus provided by the embodiments of the second aspect of the present application comprises the display panel 10 of any of the above-mentioned embodiments of the first aspect, the display apparatus provided by the embodiments of the second aspect of the present application has the beneficial effects of the display panel 10 of any of the above-mentioned embodiments of the first aspect, which will not be described in detail here.

The display apparatus in the embodiments of the present application comprises but is not limited to a mobile phone, a personal digital assistant (Personal Digital Assistant, referred to as: PDA), tablet computers, e-books, televisions, access control, smart fixed phones, consoles and other apparatuses with display functions.

Embodiments of a third aspect of the present application further provides a method for manufacturing a display panel 10, which may be the display panel 10 of any of the embodiments of the first aspect. With reference to Figs. 1 to 17 together, the method for manufacturing the display panel 10 comprises:

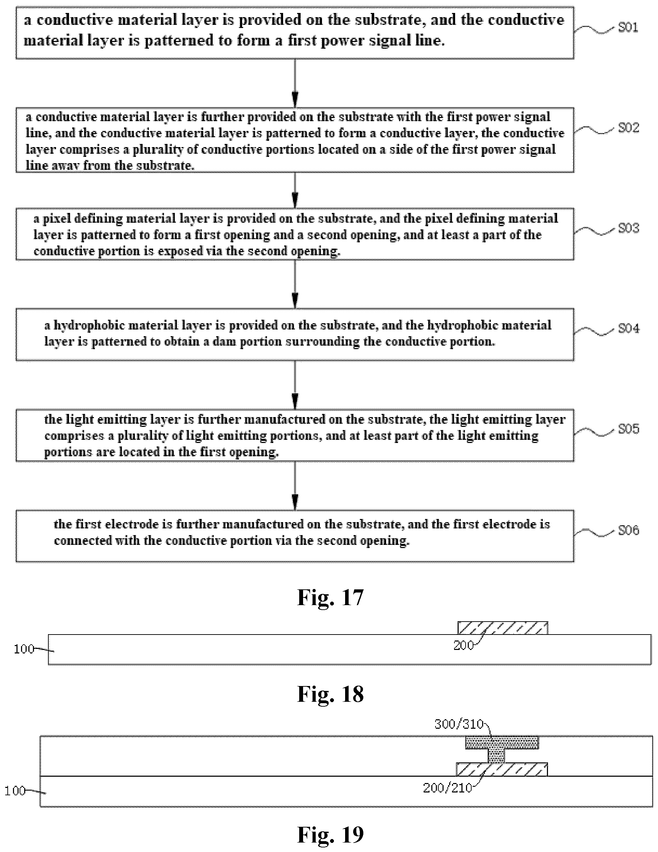

Step S01: as shown in Fig. 18, a conductive material layer is provided on the substrate 100, and the conductive material layer is patterned to form a first power signal line 200.

Step S02: as shown in Fig. 19, a conductive material layer is further provided on the substrate 100 with the first power signal line 200, and the conductive material layer is patterned to form a conductive layer 300, wherein the conductive layer 300 comprises a plurality of conductive portions 310 located on a side of the first power signal line 200 away from the substrate 100.

Optionally, when the conductive portion 310 and the first power signal line 200 are located in adjacent film layer structures and are directly contacted and connected with each other, a conductive material layer can be further provided on the substrate 100 with the first power signal line 200 and the conductive material layer can be patterned to form the conductive layer 300.

Optionally, when the conductive portion 310 and the first power signal line 200 are located in different film layer structures and the conductive portion 310 is connected with the first power signal line 200 through a via, before step S02, an insulating material layer is further provided on the substrate 100 with the first power signal line 200, and the insulating material is patterned to form a via hole. In step S02, a conductive material layer is further provided on the insulating material layer, and the conductive material layer is patterned to form a conductive layer 300.

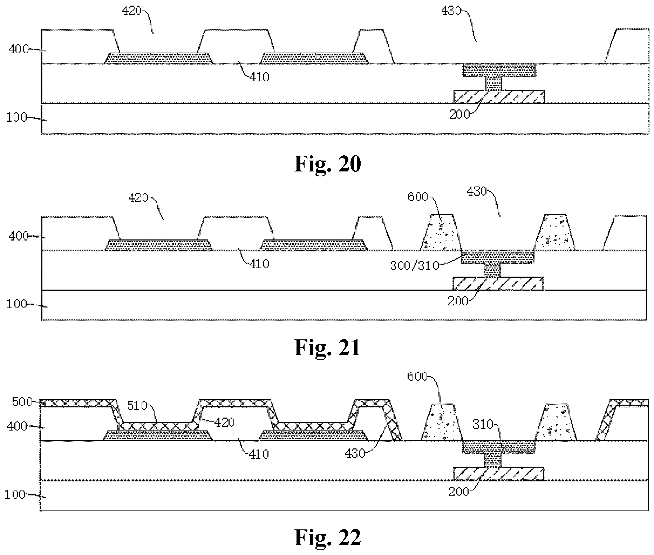

Step S03: as shown in Fig. 20, a pixel defining material layer is provided on the substrate 100, and the pixel defining material layer is patterned to form a first opening 420 and a second opening 430, and at least part of the conductive portion 310 is exposed via the second opening 430.

Step S04: as shown in Fig. 21, a hydrophobic material layer is provided on the substrate 100, and the hydrophobic material layer is patterned to obtain a dam portion 600 surrounding the conductive portion 310.

Alternatively, as described above, the dam portion 600 may be located on the pixel defining portion 410, or the dam portion 600 may be located on the substrate 100 exposed via the second opening 430.

Step S05: as shown in Fig. 22, the light emitting layer 500 is further manufactured on the substrate 100. The light emitting layer 500 comprises a plurality of light emitting portions 510, and at least part of the light emitting portions 510 are located in the first openings 420.

Step S06: as shown in Fig. 6, the first electrode 700 is further manufactured on the substrate 100, and the first electrode 700 is connected with the conductive portion 310 via the second opening 430.

In the display panel 10 manufactured by the method provided in the embodiments of the present application, the light emitting portion 510 of the light emitting layer 500 is provided in the first opening 420 formed in the pixel defining portion 410, and the problem of color crosstalk of different light emitting portions 510 can be improved by the pixel defining portion 410. A second opening 430 is further provided on the pixel defining portion 410, and the orthographic projection of the second opening 430 on the substrate 100 and the orthographic projection of the conductive portion 310 on the substrate 100 at least partially overlap, so that the conductive portion 310 can be exposed via the second opening 430, and the first electrode 700 can be connected with the conductive portion 310 via the second opening 430. The conductive portion 310 of the conductive layer 300 is connected with the first power signal line 200, thus the first electrode 700 can be connected with the first power signal line 200 via the conductive portion 310, which can improve the problem of excessive voltage drop of the first electrode 700 and improve the display effect of the display panel 10. In addition, the substrate 100 is further provided with a dam portion 600 surrounding the conductive portion 310. When manufacturing the light emitting portion 510, the blocking effect of the dam portion 600 can improve the problem of the material of the light emitting portion 510 overflowing onto the conductive portion 310 and affecting the electrical connection of the first electrode 700 and the conductive portion 310, thereby improving the connection yield of the first electrode 700 and the conductive portion 310, better improving the voltage drop problem of the first electrode 700, and improving the display effect of the display panel 10. Therefore, embodiments of the present application can improve the display performance of the display panel 10 by providing the dam portion 600.

Optionally, as described above, the display panel 10 comprises an overlapping area DA. Optionally, the light emitting portion 510 may comprise a connecting opening located in the overlapping area DA, the conductive portion 310 is provided in the overlapping area DA, and the extension dimension of the overlapping area DA in the first direction X is greater than its extension dimension in the second direction Y. Then in step S05, a plurality of nozzles provided side by side may be moved along the first direction X to apply the light emitting material on the substrate 100, and one or more adjacent nozzles are closed for a preset time period to form the light emitting portion 510 comprising the connecting opening in the overlapping area DA.

In these optional embodiments, when the light emitting material is applied on the substrate 100 by inkjet printing, for example, when the light emitting material is sprayed toward the substrate 100 by a row of nozzles provided along the second direction Y, the row of nozzles moves along the first direction X, so that the light emitting material can be sprayed on the entire substrate 100. By closing one or two adjacent nozzles in a row, the strip-shaped overlapping area DA on the substrate 100 will not be directly sprayed with the light emitting material, thereby improving the problem of the conductive portion 310 being covered by the light emitting material and affecting its connection with the first electrode 700.

In some other embodiments, in step S05, the light emitting material may be printed on the substrate 100 using a pixel-level or non -pixel-level printing technology.

Although the present application has been described with reference to preferred embodiments, various modifications may be made thereto and parts thereof may be replaced with equivalents without departing from the scope of the present application. In particular, various technical features mentioned in the various embodiments may be combined in any manner as long as there are no structural conflicts. The present application is not limited to the specific embodiments disclosed herein, but comprises all technical solutions falling within the scope of the claims.

## Claims

1. A display panel (10), comprising:
a substrate (100);
a first power signal line (200) provided on the substrate (100);
a conductive layer (300) provided over the first power signal line (200) and connected with the first power signal line (200), the conductive layer (300) comprising a plurality of conductive portions (310);
a pixel defining layer (400) comprising pixel defining portions (410), first openings (420) and second openings (430) that are formed in the pixel defining portions (410), orthographic projections of the second openings (430) on the substrate (100) and orthographic projections of the conductive portions (310) on the substrate (100) at least partially overlapping;
a light emitting layer (500) provided on a side of the substrate (100) where the conductive layer (300) is located, the light emitting layer (500) comprising a plurality of light emitting portions (510) disposed corresponding to the first openings (420);
dam portions provided on the substrate (100) and surrounding the plurality of conductive portions (310), a material of the dam portions having no affinity with a material of the light emitting portions (510);
first electrodes provided on a side of the light emitting layer (500) and the dam portions away from the substrate (100) and connected with the conductive portions (310) via the second openings (430).

2. The display panel (10) of claim 1, wherein the dam portions are located on a side of the pixel defining portions (410) away from the substrate (100) and are provided surrounding the second openings (430).

3. The display panel (10) of claim 2, wherein the pixel defining portions (410) comprise first sections (411) and second sections (412) spaced apart from each other, the first openings (420) are formed in the first sections (411), the second openings (430) are formed in the second sections (412), the dam portions are located on a side of the second sections (412) away from the substrate (100), and/or
wherein the dam portions have first surfaces facing away from the substrate (100), and the first sections (411) have second surfaces (401) facing away from the substrate (100), the first surfaces are located on a side of the second surfaces (401) facing away from the substrate (100).

4. The display panel (10) of any one of the preceding claims, wherein orthographic projections of the dam portions on the substrate (100) are located within the second openings (430), and the dam portions are in direct contact with the substrate (100) via the second openings (430), and/or
wherein inner wall surfaces, facing the second openings (430), of the pixel defining portions (410) are spaced apart from the dam portions.

5. The display panel (10) of any one of the preceding claims, further comprising overlapping areas (DA) distributed at intervals, wherein the plurality of conductive portions (310) are located in the overlapping areas (DA);
the dam portions (600) are located in the overlapping areas (DA);
the plurality of conductive portions (310) are distributed at intervals along an extension direction of the overlapping areas (DA).

6. The display panel of any one of the preceding claims, wherein orthographic projections of the conductive portions (310) on the substrate (100) each are in a circular shape;
orthographic projections of the dam portions (600) on the substrate (100) each are in a circular ring shape.

7. The display panel (10) of claim 5, wherein the overlapping areas (DA) are in strip shapes, and are provided side by side along a first direction and/or a second direction, the first direction is intersected with the second direction;
the extension dimension of the overlapping areas (DA) in the second direction is greater than the extension dimension of the overlapping areas (DA) in the first direction, and the overlapping areas (DA) are provided side by side along the first direction;
a width of one of the overlapping areas (DA) in the first direction is 10 µm to 50 µm, and a length of one of the overlapping areas (DA) in the second direction is greater than or equal to 10 µm;
a distance between two adjacent ones of the overlapping areas (DA) is greater than or equal to 5 µm.

8. The display panel (10) of claim 5, further comprising a display area (AA), wherein the overlapping areas (DA) are evenly distributed in the display area (AA);
the overlapping areas (DA) each are in a square shape;
a distance between adjacent two of the overlapping areas (DA) is less than or equal to 50 µm, or a spacing between adjacent two of the overlapping areas (DA) is greater than or equal to 80 µm .

9. The display panel (10) of any one of the preceding claims, wherein the dam portions (600) have side surfaces (630) facing and being connected with the bottom surface (620) of the substrate (100), and extending away from the substrate (100), an angle between the side surfaces (630) and the bottom surface (620) is greater than or equal to 10 degrees and less than or equal to 70 degrees, and/or wherein a thickness di of one of the dam portions (600) and a thickness d₂ of one of the light emitting portions (510) satisfy the following condition: d₁≥15d₂;
and/or, the thickness di of one of the dam portions (600) is 200nm to 10µm;
and/or, a width of one of the dam portions (600) is 2 µm to 10 µm.

10. The display panel (10) of any one of the preceding claims, wherein surfaces of the conductive portions (310) facing the first electrodes (700) are provided with grooves (311);
the grooves (311) are provided at intervals, and
wherein each of the grooves (311) extends along the first direction (X), and the grooves (311) are provided side by side along the second direction (Y).

11. The display panel (10) of any one of the preceding claims, further comprising a second electrode layer (800) located on a side of the pixel defining layer (400) facing the substrate (100), and the second electrode layer (800) comprising second electrodes (810) provided corresponding to the first openings (420), wherein
the conductive portions (310) and the second electrodes (810) are provided in a same layer; or,
the substrate (100) is further provided with a planarization layer located on a side of the second electrode layer (800) away from the pixel defining layer (400), the conductive layer (300) is located on a side of the planarization layer away from the second electrode layer (800), connecting holes (910) are formed in the planarization layer, and the first electrode (700) is connected with the conductive portions (310) via the connecting holes (910).

12. The display panel of any one of the preceding claims, wherein the conductive portions (310) are in contact with and connected with the first power signal line (200); or, the conductive layer (300) is connected with the first power signal line (200) through a via, and/or
wherein surfaces of the dam portions (6000) facing away from the substrate (100) is hydrophobic and/or oleophobic surfaces with low surface energy.

13. A display apparatus, comprising the display panel (10) according to any one of the preceding claims.

14. A method for manufacturing a display panel (10), comprising:
providing a conductive material layer on a substrate (100), and patterning the conductive material layer to form a first power signal line (200);
further providing a conductive material layer on the substrate (100) with the first power signal line (200), and patterning the conductive material layer to form a conductive layer (300) comprising a plurality of conductive portions (310) located on a side of the first power signal line (200) away from the substrate (100);
providing a pixel defining material layer (400) on the substrate(100), and patterning the pixel defining material layer (400) to form first openings (420) and second openings (430), at least part of the conductive portion (310) being exposed via the second openings (430);
providing a hydrophobic material layer on the substrate (100), and patterning the hydrophobic material layer to obtain dam portions (600) provided surrounding the conductive portions (310);
further manufacturing a light emitting layer (500) comprising a plurality of light emitting portions (510) on the substrate (100), the light emitting portions (510) being at least partially located in the first openings (420);
further manufacturing first electrodes (700) on the substrate (100), the first electrodes (700) being connected with the conductive portions (310) via the second openings (430).

15. The method of claim 14, wherein the display panel (10) comprises overlapping areas (DA), the light emitting portions (510) comprising connecting openings located in the overlapping areas (DA), the conductive portions (310) being provided in the overlapping areas (DA), an extension dimension of the overlapping areas (DA) in a first direction being greater than an extension dimension of the overlapping areas (DA) in a second direction, and in the step of further manufacturing the light emitting layer (500) on the substrate (100):
a plurality of nozzles provided side by side are moved along the first direction to apply a light emitting material on the substrate (100), and one or more adjacent nozzles are closed for a preset period of time to form the light emitting portion (510) comprising the connecting openings in the overlapping area (DA).
